# EUROPEAN PATENT APPLICATION

(11) **EP 2 045 285 A1**
(43) Date of publication of application: **08.04.2009**
(21) Application number: 08102849.0
(22) Date of filing: 21.03.2008
(51) Int. Cl.: C08K 3/08, C08K 3/20, B32B 5/16, H01Q 17/00, H05K 9/00, C09D 183/04

(54) **Roll-type composite sheet having improved heat-releasing, electromagnetic wave-absorbing, and impact-absorbing properties, and method of manufacturing the same**

(30) Priority: 01.10.2007 WO PCT/KR2007/098671
(71) Applicant: Doo Sung Industrial Co., Ltd., Ansan-city 425-808 Kyungki-do (KR)
(72) Inventor: An, Jung Min 101-502, Gyeongnam Professors' Apt., Seoul (KR); Park, Jong Joo 102-406 Hyundai Hometown 4-cha 1-dangji, Gyeonggi-do (KR)
(74) Representative: Capasso, Olga

(57) **Abstract**

A method of manufacturing a roll-type composite sheet including agitating a silicone gel using a mixer; agitating first powder and the silicone gel for 5 to 20 minutes to form a first mixture including at least the first powder and the silicone gel; agitating the first mixture and second powder for 5 to 20 minutes to form a second mixture; adding a solvent at least to the second mixture to form a reaction product being in a form of a paste; removing bubbles from the reaction product; coating the reaction product on a release medium at a temperature of 80 to 140°C; and curing and drying the reaction product to form the composite sheet.

## Description

### BACKGROUND OF THE INVENTION

### 1. Field of the Invention

The present invention relates to a roll-type composite sheet having improved heat-releasing, electromagnetic wave-absorbing, and impact-absorbing properties, and a method of manufacturing the roll-type composite sheet. In more particular, the present invention relates to a method of economically manufacturing a roll-type composite sheet having improved heat-releasing, electromagnetic wave-absorbing, and impact-absorbing properties by making the mixture of silicone gel, electromagnetic wave absorbing powder (Fe-Si, Fe-Cr, Fe-Ni, Fe-Al, Fe-Al-Si, or Fe-Cr-Si), and heat releasing (heat conducting) powder (alumina, silica, magnesia, silicone nitride, graphite, or carbon) in the form of a paste, coating the mixture on release paper by comma coating, and drying and curing the mixture; and a roll-type composite sheet having improved heat-releasing, electromagnetic wave-absorbing, and impact-absorbing properties that is manufactured by the method.

### 2. Description of the Related Art

As mobile devices have been miniaturized and highly integrated and have processed a large amount of data at high speed, there is a demand for electromagnetic compatibility (EMC) products that have various functions to prevent electromagnetic interference (EMI), to release heat, and to absorb vibration and impact. In particular, since foreign business enterprises of advanced countries significantly enter domestic markets, there are strong demands for the localization of components, the development of substitutional goods, and the countermeasure against the combination trend in order to ensure domestic markets and competitiveness against the foreign business enterprises.

The most important properties, which are required for the electromagnetic compatibility (EMC) products used in electric devices, electronic devices, and communication devices, include high electromagnetic wave-shielding efficiency, high electromagnetic wave-absorbing efficiency, an excellent heat-releasing (thermal conductivity) property. Further, as the devices trend to become light, slim, and compact, the electromagnetic compatibility (EMC) products should become small and slim. Meanwhile, if the products become slim, the amount of heat generated per unit area is increased. For this reason, the life span of the products may be shortened. Therefore, there is a strong demand for an electromagnetic wave-shielding/absorbing sheet having an improved heat-releasing property.

Electromagnetic wave-absorbing materials in the related art reduce radio energy or reduce reflected waves to be smaller than a reference level, by using high-frequency loss of ingredients thereof. The electromagnetic wave-absorbing materials in the related art are classified into a conductivity-loss material, a dielectric-loss material, a magnetism-loss material, and the like, depending on the raw materials thereof. A composite ferrite electromagnetic wave absorber, which is commonly used as the electromagnetic wave-absorbing material, is obtained by mixing ferrite with polymeric materials, such as silicone rubber and plastics, as supporting materials. The composite ferrite electromagnetic wave absorber is formed in the shape of a sheet having a thickness of about 1 mm, and used for antireflection of a radar in the GHz band.

An electromagnetic wave shielding material in the related art is manufactured in the shape of a conductive mesh, a conductive fiber, conductive rubber by generally mixing metals (iron, copper, nickel, and the like) with plastics. The electromagnetic wave shielding material shields or reflects the electromagnetic waves so as to avoid the direct influence from the electromagnetic waves, but is continuously exposed to electromagnetic waves. Further, when the electromagnetic wave shielding material is formed by plating copper or nickel on polyester, there is a concern that electric shocks occur.

The electromagnetic wave-shielding/absorbing sheet in the related art is formed by laminating electromagnetic wave-shielding/absorbing layers. Each of the electromagnetic wave-shielding/absorbing layers is formed by applying soft magnetic metal powder (for example, permalloy, sendust, Fe-Si, Ni-Fe, and the like) on one surface or both surfaces of a conductive layer. The electromagnetic wave-shielding/absorbing sheet has excellent electromagnetic wave-shielding/absorbing properties, but has a limitation on releasing heat that is generated from the sheet.

Each of most of the electromagnetic compatibility (EMC) products includes an electromagnetic wave shielding or absorbing layer or a thermal conductive layer, and an adhesive layer. Therefore, if the adhesive layer is damaged, the product may lose the function thereof. Meanwhile, since silicone has excellent heat resistance, an electrical insulating property, mechanical strength, and abrasion resistance, a product that is formed by coating an absorbing layer on sponge or silicone rubber or extruding the mixture of magnetic powder and silicone has been used in the related art. However, in the case of that product that is formed only by coating a conductive layer on urethane or silicone, there is a concern that the surface of the product is peeled or stains other portions. In the case of a product that is formed by extruding the mixture of the magnetic materials and silicone, there is a problem in that conductivity is decreased due to the increase of vertical resistance and surface resistance. Further, when a sheet is manufactured one by one with silicone rubber by a heat press, there is a problem in that productivity deteriorates.

### SUMMARY OF THE INVENTION

An object of the present invention is to provide a method of manufacturing a roll-type composite sheet having improved heat-releasing, electromagnetic wave-absorbing, and impact-absorbing properties, which does not need to separately include an adhesive layer, can reduce the manufacturing cost through the simplification of a manufacturing process, and can minimize a fraction defective.

Another object of the present invention is to provide a roll-type composite sheet that is applied to light, slim, and compact electric devices, electronic devices, and communication devices, and has multiple functions to efficiently release and absorb heat and electromagnetic waves generated in the devices and to efficiently absorb impact applied from the outside.

An embodiment of the present invention provides a method of manufacturing a roll-type composite sheet having improved heat-releasing, electromagnetic wave-absorbing, and impact-absorbing properties. The method includes (a) agitating 20 to 58% by weight of a silicone gel by a planetary mixer; (b) while 20 to 40% by weight of electromagnetic wave absorbing powder selected from the group consisting of Fe-Si, Fe-Cr, Fe-Ni, Fe-Al, Fe-Al-Si, and Fe-Cr-Si is passed through a mesh and added to the silicone gel, agitating the electromagnetic wave absorbing powder and the silicone gel for 5 to 20 minutes; (c) while 20 to 40% by weight of heat releasing (heat conducting) powder selected from the group consisting of alumina, silica, magnesia, silicone nitride, graphite, and carbon is passed through a mesh and added to the mixture of the electromagnetic wave absorbing powder and the silicone gel, agitating the mixture and the heat releasing powder for 5 to 20 minutes; (d) while 1 to 10% by weight of a solvent selected from the group consisting of toluene, methysiloxane, and solvent naphtha is added to the mixture and the heat releasing powder so as to adjust the viscosity of a reaction product (the mixture of the silicone gel, the electromagnetic wave absorbing powder, and the heat releasing (heat conducting) powder), making the reaction product in the form of a paste; (e) removing bubbles from the reaction product by a defoamer; and (f) coating the defoamed reaction product, which is made in the form of a paste, on release paper at a temperature of 80 to 140°C by a comma coater, and curing and drying the reaction product.

Since the ion content of the silicone gel is low, the silicone gel prevents paths of moisture causing corrosion from being generated. Accordingly, the silicone gel has durability under high temperature and humidity. Further, since the silicone gel has excellent heat/cold-resistance, the silicone gel has softness and flexibility in the wide temperature range of about -85 to 200°C. Furthermore, the silicone gel has excellent adhesive strength, optical transparency, and heat/impact-absorbing properties, and does not cause the change of electrical conductivity.

The silicone gel having the above-mentioned properties is used in the method of manufacturing the roll-type composite sheet, which has improved heat-releasing, electromagnetic wave-absorbing, and impact-absorbing properties, according to the embodiment of the present invention. Therefore, it is possible to allow the composite sheet to have excellent heat-releasing and heat/impact-absorbing properties. In addition, a separate adhesive layer does not need to be provided on the composite sheet due to the excellent adhesive strength of the silicone gel. Further, since a sheet does not need to be manufactured one by one, the manufacturing process thereof is simplified. As a result, it is possible to reduce manufacturing cost.

One or more kinds of silicone gels may be used to optimally increase the thermal conductivity, depending on the characteristics of final products. However, it is more preferable to use 20 to 58% by weight of a silicone gel in which a low viscosity silicone gel that has a viscosity of 2000 cSt (mm/s) or less at 25°C and a high viscosity silicone gel that has a viscosity more than 2000 cSt (mm/s) at 25°C are mixed with each other at a weight ratio of 2:8 to 8:2. The reason for this is to optimize the properties of the final products even after the curing. It is more preferable that the viscosity of the low viscosity silicone gel be in the range of 10 to 700 cSt (mm/s) at 25°C, and the viscosity of the high viscosity silicone gel be in the range of 3000 to 10000 cSt (mm/s) at 25°C.

It is preferable that the electromagnetic wave absorbing powder selected from the group consisting of Fe-Si, Fe-Cr, Fe-Ni, Fe-Al, Fe-Al-Si, and Fe-Cr-Si be in the form of a flake in order to maximize the effect of absorbing electromagnetic waves. It is preferable that the amount of the specific absorption rate powder to be used be in the range of 20 to 40% by weight.

It is preferable that the heat releasing (heat conducting) powder selected from the group consisting of alumina, silica, magnesia, silicone nitride, graphite, and carbon be in the form of a granule (fine particle) or a dendrite. The electromagnetic wave absorbing powder in the form of the flake has an excellent electromagnetic wave-absorbing property, but has poor vertical thermal conductivity. For this reason, the heat releasing (heat conducting) powder should be in the form of a granule (fine particle) or a dendrite in order to maximize the vertical thermal conductivity. It is preferable that the amount of the heat releasing (heat conducting) powder to be used be in the range of 20 to 40% by weight.

It is preferable that the electromagnetic wave absorbing powder and the heat releasing (heat conducting) powder be passed through the mesh and added. The reason for this is to prevent the powder from cohering.

The solvent selected from the group consisting of toluene, methysiloxane, and solvent naphtha is appropriately added in the range of 1 to 10% by weight in order to adjust the viscosity of the mixture of the silicone gel, the electromagnetic wave absorbing powder, and the heat releasing (heat conducting) powder. The reason for this is as follows: if the viscosity of the mixture is too high, it is difficult to uniformly mix the electromagnetic wave absorbing powder and the heat releasing (heat conducting) powder with the silicone gel. If the viscosity of the mixture is too low, it is difficult to manufacture a product having a desired thickness. If the low viscosity silicone gel and the high viscosity silicone gel are mixed with each other at a desired ratio, it is possible to adjust the viscosity of the mixture. However, the viscosity of the mixture may be increased depending on the amount of the electromagnetic wave absorbing powder and the heat releasing (heat conducting) powder to be added.

The solvent is added to the mixture of the silicone gel, which is sufficiently mixed and agitated, the electromagnetic wave absorbing powder, and the heat releasing (heat conducting) powder, and the reaction product is made in the form of a paste. The reason for this is to improve the simplification of the manufacturing process and efficiency.

The reaction product, which is made in the form of a paste as described above, may have bubbles therein. For this reason, it is preferable to perform a defoaming process for removing bubbles by a defoamer.

Finally, the defoamed reaction product, which is made in the form of a paste, is coated on release paper at a temperature of 80 to 140°C by a comma coater. Then the reaction product is cured and dried, so that a roll-type composite sheet is formed. In this case, if the speed of the comma coater is too high, the surface of the reaction product becomes rough. For this reason, it may be difficult to cure the reaction product. If the speed of the comma coater is too low, a production rate deteriorates. Accordingly, the speed of the comma coater should be appropriately adjusted depending on the viscosity of the paste and the temperature in the comma coater. As long as being known in the art, curing and drying conditions are not particularly limited.

Meanwhile, the method of manufacturing a roll-type composite sheet, which has improved heat-releasing, electromagnetic wave-absorbing, and impact-absorbing properties, according to the embodiment of the present invention may further include adding 1 to 3% by weight of one or more additives selected from the group consisting of a heat stabilizer, an ultraviolet stabilizer, a cross-linker, and a colorant including pigment to the mixture and the heat releasing powder, and agitating the mixture, the heat releasing powder, and the additives, between (c) the agitating of the mixture and the heat releasing powder and (d) the making of the reaction product in the form of a paste.

Another embodiment of the present invention provides a roll-type composite sheet, which has improved heat-releasing, electromagnetic wave-absorbing, and impact-absorbing properties, and is manufactured by the above-mentioned method. The hardness of the roll-type composite sheet is in the range of 50 to 70 Shore A, and the thickness thereof is in the range of 1 to 2 mm.

As time goes by, the hardness of the silicone gel is increased. Accordingly, it is important to allow the hardness of the final product to be in the range of 50 to 70 Shore A by minimizing the increase of the hardness in the consideration of the aging of the hardness when a product is manufactured. The heat-releasing, electromagnetic wave-absorbing, and impact-absorbing properties of the final product, which has hardness in the above-mentioned range, are optimized.

Meanwhile, if the thickness of the final product is less than 1 mm, the product may be ruptured. In another embodiment of the present invention, a product group having a thickness of 1 to 2 mm is the final product group. However, when a thick product is required, one or more sheets may be bonded to each other so as to manufacture a product having a desired thickness.

In the roll-type composite sheet, which has improved heat-releasing, electromagnetic wave-absorbing, and impact-absorbing properties, according to another embodiment of the present invention, a thermal conductivity measured by an ASTM D5470 method is 1.5 W/m·K or more and a specific absorption rate measured by a KS C0305 method at 500.3 MHz is -1.2 dB.

According to the method of manufacturing a roll-type composite sheet, which has improved heat-releasing, electromagnetic wave-absorbing, and impact-absorbing properties, of the present invention, an adhesive layer does not need to be separately provided, and it is possible to reduce manufacturing cost through the simplification of a manufacturing process and to minimize a fraction defective. Further, the roll-type composite sheet manufactured by the method is applied to light, slim, and compact electric devices, electronic devices, and communication devices, and has multiple functions to efficiently release and absorb heat and electromagnetic waves that are generated in the devices and to efficiently absorb impact applied from the outside.

### BRIEF DESCRIPTION OF THE DRAWINGS

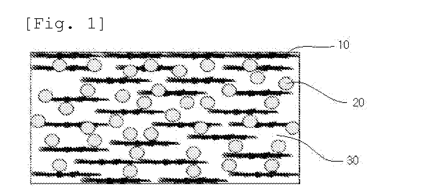

FIG. 1 is a cross-sectional view of a roll-type composite sheet, which has improved heat-releasing, electromagnetic wave-absorbing, and impact-absorbing properties, according to a preferred embodiment of the present invention; and

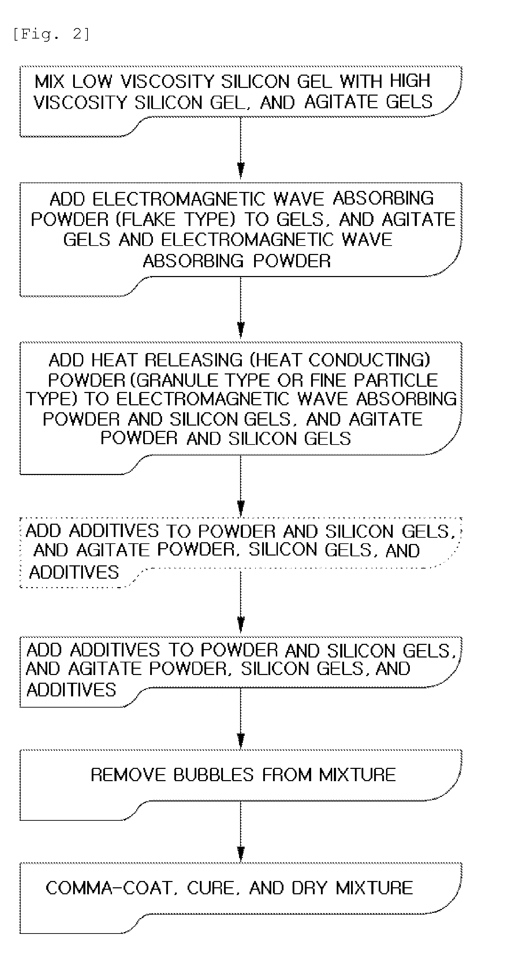

FIG. 2 is a flowchart illustrating a method of manufacturing a roll-type composite sheet, which has improved heat-releasing, electromagnetic wave-absorbing, and impact-absorbing properties, according to another preferred embodiment of the present invention.

### DESCRIPTION OF THE PREFERRED EMBODIMENTS

The present invention will be described in more detail with reference to the following examples. However, since the examples are used to merely exemplify the present invention, it should be understood that the scope of the present invention is not limited to the examples. Therefore, persons with ordinary skill in the art to which the invention pertains (so-called "those skilled in the art" or "ordinary engineers") will understand that the following examples may be changed, modified, and applied in various ways within the scope derived from appended claims.

### Example 1

A method of manufacturing a roll-type composite sheet includes agitating a silicone gel using a planetary mixer or the like. While first powder is being passed through a mesh and being added to the silicone gel, agitating the first powder and the silicone gel for 5 to 20 minutes to form a first mixture including at least the first powder and the silicone gel. The first powder is one selected from the group consisting of Fe-Si, Fe-Cr, Fe-Ni, Fe-Al, Fe-Al-Si, Fe-Cr-Si, and a combination thereof.

While second powder is being passed through a mesh and being added to a first mixture, the first mixture and the second powder agitated for 5 to 20 minutes to form a second mixture including at least the first mixture and the second powder. The second powder is one selected from the group consisting of alumina, silica, magnesia, silicone nitride, graphite, carbon, and a combination thereof.

A solvent is added at least to the second mixture to form a reaction product being in a form of a paste, the reaction product including at least the second mixture and the solvent. The solvent is one selected from the group consisting of toluene, methysiloxane, solvent naphtha, and a combination thereof. The reaction product has a different viscosity than the second mixture.

The method further includes removing bubbles from the reaction product using a defoamer and coating the defoamed reaction product on a release paper at a temperature of 80 to 140°C using a comma coater, and then curing and drying the reaction product.

In the present example, the silicone gel is 20 to 58% by weight of Vinly-dimethly polysiloxane. The first powder is electromagnetic wave absorbing powder and is 20 to 40% by weight of Fe-Si-Cr, Fe-Al-Si, Mn-Zn Ferrite, Ni-Zn Ferrite, or Fe-Ni, or a combination thereof. The second powder is heating releasing powder or heat conducting powder, and is 20 to 40% by weight of Alumina, silica, magnesia, or graphite, or a combination thereof. The solvent is 1 to 10% by weight of toluene, methyl polysiloxnae, or hexane, or a combination thereof.

In the present example, the silicone gel includes two types: (1) a low viscosity silicone gel that has a viscosity of no more than 2000 cSt (mm/s) at 25°C, and (2) a high viscosity silicone gel that has a viscosity of more than 2000 cSt (mm/s) at 25°C, wherein a weight ratio of the low viscosity silicone gel and the high viscosity silicone gel is 2:8 to 8:2. For example, the low viscosity silicone gel has the viscosity of no more than to 700 cSt (mm/s) at 25°C. The high viscosity silicone gel has the viscosity of 3000 to 10000 cSt(mm/s) at 25°C.

In one implementation, the first powder is in the form of a flake, and the second powder is in the form of a granule or a dendrite.

In yet another implementation, the method further includes adding one or more additives to the second powder; and agitating the one or more additives and the second mixture prior to forming the reaction product, the one or more additives being 1 to 3% by weight of Pt catalyst, DMA (dimethly amine), or DBTDL (dibutyltin dilaurate), or a combination thereof. The one or more additives is one selected from the group consisting of a heat stabilizer, an ultraviolet stabilizer, a cross-linker, and a colorant including pigment to the second mixture.

In yet another implementation, the composite sheet has a hardness in the range of 50 to 70 Shore A, and a thickness in the range of 1 to 2 mm.

### Example 2

A method of manufacturing a roll-type composite sheet includes agitating a silicone gel using a mixer, e.g., a planetary mixer. First powder and the silicone gel are agitated for 5 to 20 minutes to form a first mixture including at least the first powder and the silicone gel. The first powder is one selected from the group consisting of Fe-Si, Fe-Cr, Fe-Ni, Fe-Al, Fe-Al-Si, Fe-Cr-Si, and a combination thereof.

The first mixture and second powder are agitated for for 5 to 20 minutes to form a second mixture including at least the first mixture and the second powder. The second powder is one selected from the group consisting of alumina, silica, magnesia, silicone nitride, graphite, carbon, and a combination thereof.

A solvent is added at least to the second mixture to form a reaction product being in a form of a paste. The reaction product includes at least the second mixture and the solvent. The solvent is one selected from the group consisting of toluene, methysiloxane, solvent naphtha, and a combination thereof.

The method further includes removing bubbles from the reaction product; coating the reaction product on a release medium at a temperature of 80 to 140°C; and curing and drying the reaction product to form the composite sheet.

In the present example, the silicone gel is 20 to 58% by weight of Vinly-dimethly polysiloxane. The first powder is electromagnetic wave absorbing powder and is 20 to 40% by weight of Fe-Si-Cr, Fe-Al-Si, Mn-Zn Ferrite, Ni-Zn Ferrite, or Fe-Ni, or a combination thereof. The second powder is heating releasing powder or heat conducting powder, and is 20 to 40% by weight of Alumina, silica, magnesia, or graphite, or a combination thereof. The solvent is 1 to 10% by weight of toluene, methyl polysiloxnae, or hexane, or a combination thereof.

The silicone gel has at least two types of gel: (1) a first silicone gel that has a viscosity of no more than 2000 cSt (mm/s) at 25°C, and (2) a second silicone gel that has a viscosity of more than 2000 cSt (mm/s) at 25°C, wherein a weight ratio of the first silicone gel and the second silicone gel is 1:4 to 4:1. In one implementation, the first silicone gel has the viscosity of no more than to 700 cSt(mm/s) at 25°C. In one implementation, the second silicone gel has the viscosity of 3000 to 10000 cSt (mm/s) at 25°C.

The first powder is in the form of a flake, and the second powder is in the form of a granule or a dendrite.

The method further includes adding one or more additives to the second powder; and agitating the one or more additives and the second mixture prior to forming the reaction product. The one or more additives is 1 to 3% by weight of Pt catalyst, DMA (di-methly amine), or DBTDL (dibutyltin dilaurate), or a combination thereof. Each additive is one selected from the group consisting of a heat stabilizer, an ultraviolet stabilizer, a cross-linker, and a colorant including pigment to the second mixture.

## Claims

1. A method of manufacturing a roll-type composite sheet, the method comprising:
agitating a silicone gel using a planetary mixer; while first powder is being passed through a mesh and being added to the silicone gel, agitating the first powder and the silicone gel for 5 to 20 minutes to form a first mixture including at least the first powder and the silicone gel, the first powder being one selected from the group consisting of Fe-Si, Fe-Cr, Fe-Ni, Fe-Al, Fe-Al-Si, Fe-Cr-Si, and a combination thereof;
while second powder is being passed through a mesh and being added to a first mixture, agitating the first mixture and the second powder for 5 to 20 minutes to form a second mixture including at least the first mixture and the second powder, the second powder being one selected from the group consisting of alumina, silica, magnesia, silicone nitride, graphite, carbon, and a combination thereof;
adding a solvent at least to the second mixture to form a reaction product being in a form of a paste, the reaction product including at least the second mixture and the solvent, the solvent being one selected from the group consisting of toluene, methysiloxane, solvent naphtha, and a combination thereof, the reaction product having a different viscosity than the second mixture; removing bubbles from the reaction product using a defoamer; and
coating the defoamed reaction product on a release paper at a temperature of 80 to 140°C using a comma coater, and curing and drying the reaction product.

2. The method of claim 1, wherein the silicone gel is 20 to 58% by weight of Vinly-dimethly polysiloxane.

3. The method of claim 2, wherein the first powder is electromagnetic wave absorbing powder and is 20 to 40% by weight of Fe-Si-Cr, Fe-Al-Si, Mn-Zn Ferrite, Ni-Zn Ferrite, or Fe-Ni, or a combination thereof.

4. The method of claim 3, wherein the second powder is heating releasing powder or heat conducting powder, and is 20 to 40% by weight of Alumina, silica, magnesia, or graphite, or a combination thereof.

5. The method of claim 4, wherein the solvent is 1 to 10% by weight of toluene, methyl polysiloxnae, or hexane, or a combination thereof.

6. The method of claim 5, wherein the silicone gel having a low viscosity silicone gel that has a viscosity of no more than 2000 cSt (mm/s) at 25°C and a high viscosity silicone gel that has a viscosity of more than 2000 cSt (mm/s) at 25°C, wherein a weight ratio of the low viscosity silicone gel and the high viscosity silicone gel is 2:8 to 8:2.

7. The method of claim 6, wherein the low viscosity silicone gel has the viscosity of no more than to 700 cSt (mm/s) at 25°C.

8. The method of claim 6, wherein the high viscosity silicone gel has the viscosity of 3000 to 10000 cSt (mm/s) at 25°C.

9. The method of claim 5, wherein the first powder is in the form of a flake, and the second powder is in the form of a granule or a dendrite.

10. The method of claim 5, further comprising:
adding one or more additives to the second powder;
agitating the one or more additives and the second mixture prior to forming the reaction product, the one or more additives being 1 to 3% by weight of Pt catalyst, DMA (dimethly amine), or DBTDL (dibutyltin dilaurate), or a combination thereof, the one or more additives being one selected from the group consisting of a heat stabilizer, an ultraviolet stabilizer, a cross-linker, and a colorant including pigment to the second mixture.

11. A roll-type composite sheet that is manufactured by the method of claim 5, wherein the composite sheet has a hardness in the range of 50 to 70 Shore A, and the composite sheet has a thickness in the range of 1 to 2 mm.

12. A method of manufacturing a roll-type composite sheet, the method comprising:
agitating a silicone gel using a mixer;
agitating first powder and the silicone gel for 5 to 20 minutes to form a first mixture including at least the first powder and the silicone gel, the first powder being one selected from the group consisting of Fe-Si, Fe-Cr, Fe-Ni, Fe-Al, Fe-Al-Si, Fe-Cr-Si, and a combination thereof;
agitating the first mixture and second powder for 5 to 20 minutes to form a second mixture including at least the first mixture and the second powder, the second powder being one selected from the group consisting of alumina, silica, magnesia, silicone nitride, graphite, carbon, and a combination thereof;
adding a solvent at least to the second mixture to form a reaction product being in a form of a paste, the reaction product including at least the second mixture and the solvent, the solvent being one selected from the group consisting of toluene, methysiloxane, solvent naphtha, and a combination thereof;
removing bubbles from the reaction product;
coating the reaction product on a release medium at a temperature of 80 to 140°C; and
curing and drying the reaction product to form the composite sheet.

13. The method of claim 12, wherein the silicone gel is 20 to 58% by weight of Vinly-dimethly polysiloxane, wherein the first powder is electromagnetic wave absorbing powder and is 20 to 40% by weight of Fe-Si-Cr, Fe-Al-Si, Mn-Zn Ferrite, Ni-Zn Ferrite, or Fe-Ni, or a combination thereof, wherein the second powder is heating releasing powder or heat conducting powder, and is 20 to 40% by weight of Alumina, silica, magnesia, or graphite, or a combination thereof, and wherein the solvent is 1 to 10% by weight of toluene, methyl polysiloxnae, or hexane, or a combination thereof.

14. The method of claim 13, wherein the silicone gel having a first silicone gel that has a viscosity of no more than 2000 cSt(mm/s) at 25°C and a second silicone gel that has a viscosity of more than 2000 cSt (mm/s) at 25°C, wherein a weight ratio of the first silicone gel and the second silicone gel is 1:4 to 4:1.

15. The method of claim 13, wherein the first silicone gel has the viscosity of no more than to 700 cSt (mm/s) at 25°C.

16. The method of claim 13, wherein the second silicone gel has the viscosity of 3000 to 10000 cSt (mm/s) at 25°C.

17. The method of claim 13, wherein the first powder is in the form of a flake, and the second powder is in the form of a granule or a dendrite.

18. The method of claim 12, further comprising:
adding one or more additives to the second powder;
agitating the one or more additives and the second mixture prior to forming the reaction product, the one or more additives being 1 to 3% by weight of Pt catalyst, DMA (di-methly amine), or DBTDL (dibutyltin dilaurate), or a combination thereof, each additive being one selected from the group consisting of a heat stabilizer, an ultraviolet stabilizer, a cross-linker, and a colorant including pigment to the second mixture.
